# FASCICULE DE BREVET EUROPEEN

(11) **EP 2 438 072 B1**
(45) Date de publication et mention de la délivrance du brevet: **23.11.2016**
(21) Numéro de dépôt: 10723533.5
(22) Date de dépôt: 01.06.2010
(51) Int. Cl.: C07F 3/00, C07F 3/02, C08F 4/622, C08F 2/00

(54) **NOUVEAUX COMPOSES ORGANOMETALLIQUES A BASE D'UN METAL APPARTENANT A LA 2EME COLONNE DE LA CLASSIFICATION PERIODIQUE ET PROCEDE DE PREPARATION**
NEUE METALLORGANISCHE VERBINDUNGEN, DIE EIN ZUR ZWEITEN SPALTE DES PERIODENSYSTEMS GEHÖRENDES METALL ENTHALTEN, UND VERFAHREN ZU DEREN HERSTELLUNG
NOVEL ORGANOMETALLIC COMPOUNDS CONTAINING A METAL BELONGING TO THE SECOND COLUMN OF THE PERIODIC TABLE, AND METHOD FOR PREPARING SAME

(30) Priorité: 02.06.2009 FR 0902652
(43) Date de publication de la demande: 11.04.2012
(73) Titulaire: COMPAGNIE GENERALE DES ETABLISSEMENTS MICHELIN, 63000 Clermont-Ferrand (FR); MICHELIN Recherche et Technique S.A., 1763 Granges-Paccot (CH); Centre National de la Recherche Scientifique, 75794 Paris Cedex 16 (FR); Ecole Polytechnique, 91128 Palaiseau Cedex (FR)
(72) Inventeur: CORTIAL, Guillaume, 63000 Clermont-Ferrand (FR); LE FLOCH, Pascal, DECEASED (FR); NIEF, François, 92160 Antony (FR); THUILLIEZ, Julien, 63040 CLERMONT-FERRAND Cedex 9 (FR); HERVAGAULT, Françoise, 91400 Orsay (FR); Le FLOCH, Elaine, 91400 Orsay (FR); Le FLOCH, Clémence, 91400 Orsay (FR); LE FLOCH, Paul, 91400 Orsay (FR)
(74) Mandataire: Le Cam, Véronique Marie Christine
(86) Numéro de dépôt international: PCT/EP2010/003307
(87) Numéro de publication internationale: WO 2010/139450

(56) Documents cités:
- EP-B1- 1 509 557
- HARDER, SJOERD ET AL: "Dimeric Benzylcalcium Complexes: Influence of THF in Stereoselective Styrene Polymerization" ORGANOMETALLICS , 21(11), 2268-2274 CODEN: ORGND7; ISSN: 0276-7333, 2002, XP002561496

## Description

La présente invention concerne un nouveau composé organométallique à base d'un métal divalent appartenant à la 2^{ème} colonne de la classification périodique utilisable comme co-catalyseur alkylant dans un système catalytique pour la polymérisation à base d'un métal de terre rare. La présente invention concerne également un procédé de préparation de ce nouveau composé organométallique.

Depuis que les économies de carburant et la nécessité de préserver l'environnement sont devenues une priorité, il est souhaitable de produire des mélanges possédant de bonnes propriétés mécaniques et une hystérèse aussi faible que possible afin de pouvoir les mettre en oeuvre sous forme de compositions de caoutchouc utilisables pour la fabrication de divers produits semi-finis entrant dans la composition de pneumatiques, tels que par exemple des sous-couches, des flancs, des bandes de roulement, et afin d'obtenir des pneumatiques possédant une résistance au roulement toujours plus réduite. Pour atteindre un tel objectif, il a été proposé de modifier la structure des polymères et des copolymères diéniques en fin de polymérisation au moyen d'agents de fonctionnalisation, d'agents de couplage ou d'agents d'étoilage afin d'introduire sur l'élastomère une fonction interactive vis-à-vis de la charge (ou des charges) utilisées dans la composition de caoutchouc.
La très grande majorité de ces solutions s'est d'abord concentrée sur l'utilisation de polymères fonctionnalisés qui sont actifs vis-à-vis du noir de carbone, dans le but d'obtenir une bonne interaction entre le polymère ainsi modifié et le noir de carbone.
Plus récemment, des élastomères modifiés qui sont actifs vis-à-vis de la silice ont été développés dans le but d'obtenir une bonne interaction entre le polymère ainsi modifié et la silice.
Lorsque les élastomères diéniques sont obtenus par polymérisation des monomères en présence d'un système catalytique à base de terre rare, tel que décrit notamment dans les documents de brevet EP1355960 A1 ou EP1509557 B1 des Demanderesses, on peut envisager une fonctionnalisation avec des agents portant une fonction adaptée à l'application envisagée pour l'élastomère diénique fonctionnalisé.
A titre d'agent fonctionnalisant utilisable pour cette étape de fonctionnalisation, on peut envisager ceux utilisés dans l'art antérieur pour fonctionnaliser les élastomères diéniques issus de la polymérisation anionique en présence d'un catalyseur à base d'un composé organique d'un métal alcalin.
A titre d'illustration de cet art antérieur relatif à l'interaction avec du noir de carbone, on peut par exemple citer la modification en bout de chaîne d'élastomères diéniques par des agents tels que la 4,4'-bis (diéthylamino)benzophénone comme décrit dans le document de brevet US-B-4,550,142 ou des dérivés halogénés de l'étain, ou encore le greffage le long de la chaîne polymérique de fonctions actives vis-à-vis du noir de carbone.
A titre d'illustration de cet art antérieur relatif à l'interaction avec de la silice, on peut citer par exemple le brevet américain US-A-5,066,721, qui décrit une composition de caoutchouc comprenant un polymère diénique fonctionnalisé par un alkoxysilane ayant au moins un reste alkoxyle non hydrolysé. Dans les documents de brevet EP 0692492 A1 et EP 0692493 A1, au nom des Demanderesses, est décrite la fonctionnalisation d'élastomères diéniques par un groupement alcoxysilane, en utilisant un agent fonctionnel tel qu'un alcoxysilane époxydé. Le document EP 0778311 A1 divulgue des polymères diéniques portant en extrémité de chaîne une fonction silanol ou un bloc polysiloxane ayant une extrémité silanol obtenus par réaction, en fin de polymérisation, de polysiloxanes cycliques sur les polymères vivants.
La voie de synthèse de polymères fonctionnalisés en mettant en oeuvre un système catalytique à base de terre rare, présente l'avantage de conduire à des élastomères diéniques possédant des fonctions chimiques en bout de chaîne de structure variée, selon le choix de l'agent fonctionnel utilisé.
Un inconvénient toutefois est que la synthèse comporte plusieurs étapes, ce qui peut conduire à un coût plus élevé lors de la fabrication d'un tel polymère à l'échelle industrielle, par exemple lié à l'utilisation d'un nombre de réacteurs plus élevés et donc à une mise en oeuvre compliquée.
Un autre inconvénient est la maîtrise de la pureté de l'agent fonctionnalisant, qui selon les cas, peut conduire à des réactions de désactivation ou de terminaison des bouts de chaînes de polymères en croissance, à l'origine d'une proportion plus ou moins élevée de chaînes élastomériques non fonctionnalisées.

La présente invention se propose de contribuer à surmonter les inconvénients rencontrés dans l'art antérieur lors de la préparation d'élastomères fonctionnalisés.

Lors de leurs recherches, les inventeurs ont découvert un nouveau composé organométallique à base d'un métal divalent appartenant à la 2^{ème} colonne de la classification périodique. Ce composé organométallique nouveau associé à un sel métallique de terre rare est susceptible de former un système catalytique pour la polymérisation qui permet notamment de limiter les étapes de synthèse d'un élastomère diénique fonctionnalisé en bout de chaîne, tout en assurant une fonctionnalisation optimale, c'est-à-dire proche ou égal à 100%.

L'utilisation de ce nouveau composé organométallique dans système catalytique, à base d'un sel de métal de terre rare, pour la polymérisation et plus particulièrement pour la préparation d'élastomères diéniques fonctionnalisés, permet de s'affranchir de l'étape subséquente de réaction sur un agent de fonctionnalisation. Les élastomères diéniques fonctionnalisés ainsi obtenus présentent un taux élevé de fonctionnalisation, jusqu'à 100%, et peuvent être avantageusement utilisés dans des compositions de caoutchouc comprenant une charge renforçante et destinées à une application pneumatique.

Un premier objet de la présente invention est donc un composé organométallique nouveau à base d'un métal appartenant à la 2^{ème} colonne de la classification périodique. L'invention a également pour objet un procédé de préparation de ce composé nouveau. Un autre objet de l'invention est l'utilisation de ce composé nouveau comme co-catalyseur dans un système catalytique à base d'un sel de métal de terre rare.

Bien entendu, par l'expression "à base de" utilisée pour définir les constituants du système catalytique, on entend le mélange de ces constituants et/ou le produit de la réaction entre ces constituants. D'autre part, tout intervalle de valeurs désigné par l'expression "entre a et b" représente le domaine de valeurs allant de plus de a à moins de b (c'est-à-dire bornes a et b exclues) tandis que tout intervalle de valeurs désigné par l'expression "de a à b" signifie le domaine de valeurs allant de a jusqu'à b (c'est-à-dire incluant les bornes strictes a et b).

Ainsi un premier objet de l'invention est un composé organométallique à base d'un métal appartenant à la 2^{ème} colonne de la classification périodique et répondant à la formule (I): 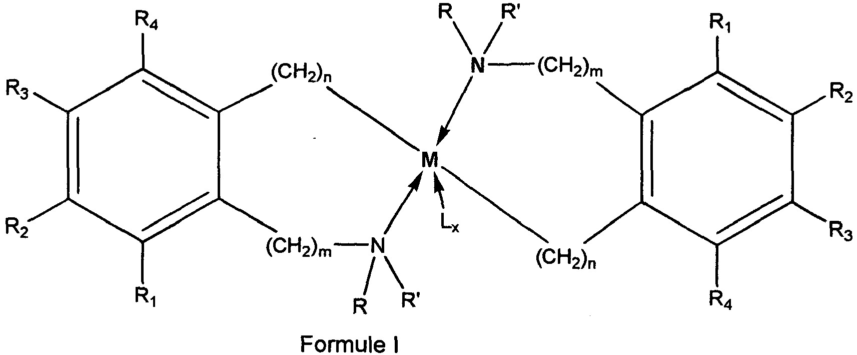 dans laquelle,

M est un métal appartenant à la 2^{ème} colonne de la classification périodique, choisi parmi Be, Mg, Sr, Ba, et Ra;
R1, R2, R3, R4, identiques ou différents entre eux, sont des atomes d'hydrogène ou des substituants alkyles, linéaires ou ramifiés, ou aryles, substitués ou non, éventuellement liés entre eux (Rᵢ est alors lié à Rᵢ₊₁) pour former au moins un cycle composé de 5 ou 6 atomes, ou au moins un noyau aromatique;
R et R' désignent des substituants alkyles, linéaires ou ramifiés, ou aromatiques, substitué ou non, identiques ou différents entre eux ;
L est une base de Lewis ;
x est un nombre entier qui vaut 0, 1, 2, 3 ou 4 ;
m est un nombre entier égal ou supérieur à 0 et inférieur ou égal à 3 ;
n est un nombre entier égal ou supérieur à 1 et inférieur ou égal à 3.

Dans cette formule (I), M est de préférence le magnésium;
Lorsque R1, R2, R3 ou R4 désigne un substituant alkyle, celui est de préférence en C₁-C₁₂, et plus préférentiellement encore C₁-C₆
Lorsque R1, R2, R3 ou R4 désigne un substituant aryle, celui est de préférence en C₆-C₁₂, et plus préférentiellement encore C₆-C₁₀
Lorsque R1, R2, R3 ou R4 sont liés entre eux pour former un cycle à 5 ou 6 atomes de carbone, le motif obtenu est de préférence composé de 2 à 4 noyaux aromatiques conjugués, et plus préférentiellement de 2 à 3 noyaux ;
De préférence R1, R2, R3 et R4 sont des atomes d'hydrogène.
Lorsque R ou R' désigne un substituant alkyle, celui est de préférence en C₁-C₆, et plus préférentiellement encore C₁-C₄ ;
Lorsque R ou R' désigne un substituant aryle, celui est de préférence en C₅-C₁₂, et plus préférentiellement encore C₅-C₆ ;
De préférence R et R' sont des groupements méthyle, éthyle, iso-propyle, n-butyle, iso-butyle ou tert-butyle.
Dans la formule (I), n est un nombre entier de préférence égal à 1.
Dans la formule (I), m est un nombre entier préférentiellement égal à 0 ou 1, m est plus préférentiellement égal à 1.
Dans la formule (I), L est une base de Lewis. Selon l'invention la base de Lewis est particulièrement choisie parmi les amines ou les éthers. De préférence la base de Lewis est la pyridine ou le tétrahydrofurane (THF).
A titre de composé organométallique de formule (I), on peut citer à titre d'exemple le bis(ortho-N,N-diméthylaminobenzyle) de magnésium, pour lequel R1, R2, R3 et R4 sont des atomes d'hydrogène, R et R' sont des groupements méthyle, m vaut 0, n vaut 1, x vaut 1 et L est le THF.
HARDER, SJOERD ET AL., ORGANOMETALLICS, 21(11), 2268-2274, 2002, décrit l'utilisation du composé bis-[o-(diméthylamino)benzyl]calcium pour préparer un autre complexe à base de calcium.
Un autre objet de l'invention est un procédé de synthèse d'un composé de formule (I) décrit plus haut.

Un procédé de préparation de ces composés de formule (I) selon l'invention comprend les étapes suivantes :
(a) de synthèse d'un sel à base d'un métal alcalin répondant à la formule (II) : 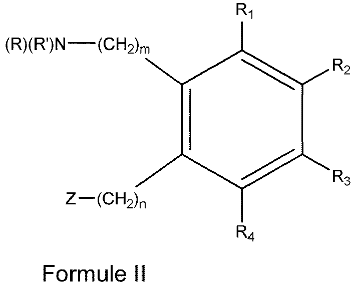 R1, R2, R3, R4, R, R', n et m sont tels que définis plus haut dans la formule (I) ; Z est un atome de lithium, de sodium ou de potassium ;
(b) de réaction du composé de formule (II) obtenu dans l'étape précédente sur un sel d'un métal appartenant à la 2ème colonne de la classification périodique, choisi parmi Be, Mg, Sr, Ba, et Ra;
(c) de récupération du composé organométallique de formule (I) obtenu.
Chacune des étapes s'effectue dans un solvant polaire ou apolaire ou dans un mélange de solvants polaire et apolaire.
A titre d'illustration, dans l'étape (a), la synthèse de sel de métal alcalin peut être réalisée à partir du diméthylaminotoluène en présence d'un composé organolithien et éventuellement d'un alcoolate de potassium.
Dans l'étape (b), le sel d'un métal appartenant à la 2^{ème} colonne de la classification périodique est de préférence un halogénure, plus particulièrement un chlorure. Le métal appartenant à la 2^{ème} colonne de la classification périodique est de préférence le magnésium. Le sel d'un métal appartenant à la 2^{ème} colonne périodique est utilisé dans des proportions telles que le rapport molaire (composé de formule (II)/sel) va de 1,5 à 2,5, de préférence de 1,8 à 2,2, encore plus préférentiellement sensiblement égal à 2.
Dans l'étape (c), la récupération du composé organométallique de formule (I) obtenu dans l'étape précédente se fait de manière connue en soi, par exemple par évaporation du solvant de synthèse ou par recristallisation dans un solvant ou un mélange de solvants. Des procédés analogues sont décrits notamment dans le document de Bailey et al. dans Chem. Eur. J. 2003, 9, 4820-4828.

L'invention a également pour objet l'utilisation d'un composé organométallique de formule (III) : 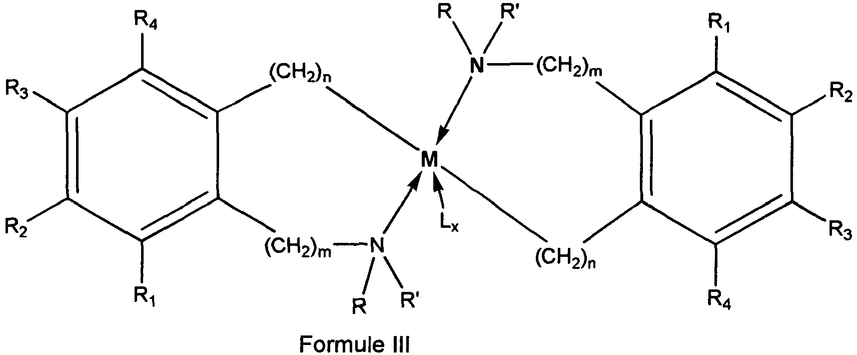 dans laquelle,
- M est un métal appartenant à la 2^{ème} colonne de la classification périodique, soit choisi parmi Be, Mg, Sr, Ba, Ra et Ca;
- R1, R2, R3, R4, identiques ou différents entre eux, sont des atomes d'hydrogène ou des substituants alkyles, linéaires ou ramifiés, ou aryles, substitués ou non, éventuellement liés entre eux pour former au moins un cycle composé de 5 ou 6 atomes, ou au moins un noyau aromatique;
- R et R', identiques ou différents entre eux, désignent des substituants alkyles, linéaires ou ramifiés, ou aryles, substitué ou non;
- L est une base de Lewis ;
- x est un nombre entier qui vaut 0, 1, 2, 3 ou 4 ;
- m est un nombre entier d'une valeur allant de 0 à 3 ;
- n est un nombre entier d'une valeur allant de 1 à 3,
comme co-catalyseur alkylant dans un système catalytique pour la polymérisation à base d'un sel métallique de terre rare.

Les aspects préférentiels de ce composé de formule (III) sont identiques à ceux du composé nouveau de formule (I) défini plus haut.
Le sel métallique de terre rare, selon l'invention, peut être représenté par la formule Ln(A)₃(B)ₙ, dans laquelle Ln est l'élément de terre rare, A est choisi parmi les halogénures, les carboxylates, les organophosphates, les alcoolates, les amidures, les alkyles ou les borohydrures et B est une ou plusieurs molécules de solvant complexée(s) sur le métal de terre rare, n est un nombre entier compris entre 0 et 3.
Par terre rare, on entend selon l'invention tout élément de la famille des lanthanides, ou l'yttrium ou le scandium. A titre préférentiel, l'élément de terre rare est choisi parmi les éléments yttrium, néodyme, gadolinium ou samarium, plus préférentiellement le néodyme ou le gadolinium.
Dans la définition de B, on entend par solvant complexé notamment des éthers, des amines, des phosphates et des thioethers. Par exemple, à titre d'amine, on peut citer la famille des trialkylamines et des amines aromatiques tels que la pyridine ou encore la pipérazine et ses dérivés. A titre de phosphate, on peut citer par exemple le tri-n-butylphosphate. A titre de thioether, on peut citer la famille des sulfures de dialkyle tels que le sulfure de diméthyle. A titre d'éther, on peut citer par exemple l'éther diéthylique, 1,2-diéthoxyéthane, 1,2-di-n-propoxyéthane, 1,2-di-n-butoxyéthane, tétrahydrofurane, dioxane, tétrahydropyrane. Plus particulièrement B est un éther, préférentiellement du tétrahydrofurane (THF).
Lorsque A est un halogénure, il est de préférence un chlorure. B est alors préférentiellement une molécule de THF et n est égal à 2.
Lorsque A est un carboxylate, celui-ci est choisi parmi les esters d'acides carboxyliques aliphatiques, linéaires ou ramifiés, ayant 6 à 16 atomes de carbone dans la chaîne linéaire, et les esters d'acides carboxyliques aromatiques comportant entre 6 et 12 atomes de carbone, substitués ou non. A titre d'exemple on peut citer le néodécanoate (versatate), le 2-éthylhexanoate, l'hexanoate, linéaires ou ramifiés, ou encore le naphthénate, substitué ou non. Parmi la famille des carboxylates, A est de préférence le 2-éthylhexanoate, le naphténate ou le néodécanoate de terre rare.
Lorsque A est choisi parmi les organophosphates, celle-ci comprend les diesters d'acide phosphorique de formule générale (R'O)(R"O)PO(OH), dans laquelle R' et R", identiques ou différents, représentent un radical alkyle, aryle ou alkylaryle. Parmi ces diesters d'acide phosphorique, R' et R", identiques ou différents, sont de préférence un radical n-butyle, isobutyle, pentyle, amyle, isopentyle, 2,2-diméthylhexyle, 1-éthylhexyle, 2-éthylhexyle, tolyle, nonaphenoxyle. Parmi la famille des organophosphates, le sel est plus préférentiellement encore le bis(2-éthylhexyl)phosphate de terre rare.
Lorsque A est choisi parmi les alcoolates, sont compris les alcoolates d'un alcool ou d'un polyol dérivé d'un hydrocarbure aliphatique ou cyclique et notamment d'un hydrocarbure aliphatique, linéaire ou ramifié, ayant 1 à 10 atomes de carbone dans la chaîne linéaire, plus particulièrement 4 à 8 atomes de carbone. On peut mentionner par exemple le néo-pentanolate.
Lorsque A est choisi parmi la famille des amidures, celle-ci comprend notamment les dialkylamidures, les N,N-bis(dialkylsilyl)amidures et les N,N-bis(trialkylsilyl)amidures, les groupements alkyles possédant entre 1 et 10 atomes de carbones.
Lorsque A est choisi parmi les dialkylamidures, B est de préférence du THF et n vaut de préférence 1. A est alors de préférence le diisopropylamidure et le diméthylamidure. Lorsque A est choisi parmi les N,N-bis(trialkylsilyl)amidures, n est de préférence égal à 0. A est alors de préférence le N,N-bis(triméthylsilyl)amidure de formule -N[Si(CH₃)₃]. Lorsque A est choisi parmi les N,N-bis(dialkylsilyl)amidures, B est de préférence du THF et n est de préférence égal à 2 ou à 3. A est alors de préférence de le N,N-bis(diméthylsilyl)amidure de formule -N[SiH(CH₃)₂].
Lorsque A est choisi parmi les familles des alkyles, A est de préférence un (trialkylsilyl)alkyle, tel que le (triméthylsilyl)méthyle ou le bis(triméthylsilyl)méthyle. Lorsque A est choisi parmi les borohydrures, A est de préférence le tétrahydroborate, B est préférentiellement le THF et n est préférentiellement égal à 2 ou 3.
Le sel métallique de terre rare est de préférence choisi parmi le tris[di(2-éthylhexyl)phosphate] de terre rare, le tri[N,N-bis(triméthylsilyl)amidure] de terre rare ou le tris(borohydrure) de terre rare.

A titre préférentiel le composé nouveau de formule (III) peut être utilisé dans un système catalytique à base d'un sel métallique de terre rare dans des proportions telles que le rapport molaire (composé de formule (III) / métal de terre rare) présente une valeur allant de 1,5 à 20 (bornes incluses), plus préférentiellement de 2 à 12.

Selon d'autres aspects de l'invention, le composé de formule (III) peut être utilisé dans un système catalytique à base d'un sel métallique de terre rare en association avec au moins un composant optionnellement présent dans ce type de système catalytique et notamment choisi parmi d'autres agents d'alkylation, des donneurs d'halogène, des diènes conjugués de préformation.

On notera que le composé organométallique de formule (III) associé à un sel métallique de terre rare est susceptible de former un système catalytique pour la polymérisation de diènes conjugués qui permet notamment de limiter les étapes de synthèse d'un élastomère diénique fonctionnalisé en bout de chaîne, tout en assurant une fonctionnalisation optimale dudit élastomère, c'est-à-dire avec un taux de fonctionnalisation allant de 75%, voire 90%, à 100%.

Les caractéristiques précitées de la présente invention, ainsi que d'autres, seront mieux comprises à la lecture de la description suivante de plusieurs exemples de réalisation de l'invention, donnés à titre illustratif et non limitatif en relation avec les annexes jointes.

### Exemples

L'ensemble des synthèses organométalliques a été réalisé sous atmosphère inerte d'argon, en utilisant soit les techniques de Schlenk soit une boîte à gants. Tous les solvants utilisés lors de ces synthèses sont séchés selon les techniques classiques (distillation sur sodium ou sur tamis moléculaire) et conservés sous atmosphère inerte. Par exemple, le pentane et le THF sont fraîchement distillés sur sodium/benzophénone. L'ensemble des réactifs proviennent de Sigma-Aldrich, Strem et Fluka.

### Synthèses

### Synthèse d'un sel de lanthanide

Nd(BH₄)₃(THF)₃ a été préparé selon un mode opératoire décrit dans la littérature S. Cendrowski-Guillaume, M. Nierlich, M. Lance, M. Ephritikhine, Organometallics, 1998, 17, 786.

### Synthèse de l'ortho-dimethylaminobenzyle de potassium [K-CH₂C₆H₄-o-NMe₂)₃]

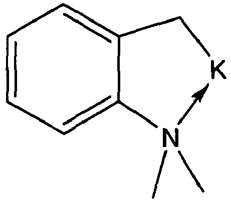

13,4 g d'*ortho*-diméthylamino-toluène (ou *N,N*-Diméthyl-o-toluidine) (M = 135 g.mol⁻¹; 99 mmol) sont dilués dans un mélange de 40 mL d'hexanes et 20 mL d'éther diéthylique. A température ambiante, sous azote et sous agitation, on ajoute 40 mL de d'une solution de butyllithium (2,5 M dans l'hexane). Après 3h, 1 équivalent de ^{t}BuOK est ajouté par fractions, sous argon. La solution se réchauffe et un précipité jaune apparaît. L'agitation est maintenue une nuit. La solution est filtrée et le précipité jaune est lavé trois fois par un mélange d'hexanes (3 x 40 mL). Après séchage sous vide, le solide est broyé et reséché sous vide une nuit. On obtient 14,9 g de poudre jaune d'*ortho*-diméthylamino-benzyle de potassium. (r = 80%). RMN ¹H (THF-d⁸, 22°C) : δ = 2,03 et 2,57 (2 x 1H, s, KCH₂-), 2,67 (s, 6H, -NMe₂), 5,11 (t, 1H, J_{H-H} = 7 Hz, CH aromatique), 6,04 (d, 1H, J_{H-H} = 7 Hz, CH aromatique), 6,16 (t, 1H, J_{H-H} = 7 Hz, CH aromatique), 6,26 (t, 1H, J_{H-H} = 7 Hz, CH aromatique).

### Synthèse du bis(ortho-N,N-diméthylaminobenzyle) de magnésium

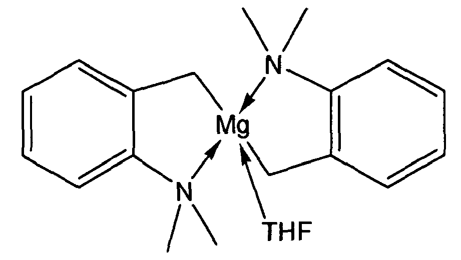

Sous argon, 0,20 g de MgCl₂ (2.1 mmol) et 0,70 g d'*ortho*-N,N-diméthylaminobenzyle de potassium (4.0 mmol) sont introduits dans un schlenk. Environ 25 mL de THF sont recondensés sous vide à -78°C. Le mélange est agité à température ambiante pendant 30 minutes, puis chauffé à reflux sous vide statique 5h, à 50°C. Les cristaux de MgCl₂ insolubles ont alors disparu. Après 1 nuit à 50°C, le mélange est centrifugé ; le culot blanc-gris de KCl est éliminé, et la solution orangée est concentrée en 1-2 mL, puis environ 0,5 mL d'éther de pétrole sont ajoutés. Des cristaux incolores apparaissent dans la solution rouge. L'analyse DRX (Annexe 4) d'un des cristaux indique une structure monomérique du complexe *bis*(ortho-N,N-diméthylaminobenzyle) de magnésium (THF). M = 0.30 g (r = 42%). RMN ¹H (thf-d8, 22°C) : δ = 7,00 (d, 2H, CH(6), J_{(C-H)} = 7 Hz), 6,90 (d, 2H, CH(3), J_{(C-H)} = 7 Hz), 6,75 (t, 2H, CH(4), J_{(C-H)} = 7 Hz), 6,55 (t, 2H, CH(5), J_{(C-H)} = 7 Hz), 3,65 (t, 4H, thf non deutéré libre), 2,65 (s, 12H, C(8) et C(9), N(CH₃)₂), 1,80 (m, 4H, thf non deutéré libre), 1,17 (s, 4H, C(1), Mg-CH₂-). RMN ¹³C (thf-d8) : δ = 152,8 (C(2)), 148,4 (C(7)), 128,9 (C(6)), 125,9 (C(4)), 118,9 (C(5)), 118,4 (C(3)), 45,7 (N(CH₃)₂), 19,0 (Mg-CH₂-).

### Polymérisations

### Mode opératoire

On utilise, à titre de réacteur de polymérisation, une bouteille "Steinie" préalablement lavée et séchée et équipée d'une capsule et d'un joint étanche à l'air et à l'humidité. Les réactions de polymérisation du butadiène sont effectuées à une température comprise entre 50 et 60 ° C et sous atmosphère inerte (azote).
Pour chaque polymérisation, on introduit du méthylcyclohexane dans ladite bouteille à titre de solvant de polymérisation. On fait barboter à l'azote ce méthylcyclohexane pendant 10 minutes pour éliminer les impuretés volatiles.
On utilise un rapport massique « solvant de polymérisation (méthylcyclohexane) / monomère (butadiène) » compris entre de 5 et 7 (ce rapport massique est appelé S/M ci-après).
Le précurseur à base de néodyme, c'est-à-dire le tris(borohydrure) de néodyme, et le co-catalyseur fonctionnel sont des composés sensibles à l'air. Pour cette raison, ils sont introduits par l'intermédiaire d'ampoules en verre scellées sous gaz inerte, qui sont ensuite brisées au début de la réaction de polymérisation.
La quantité de base catalytique en néodyme et la quantité d'agent d'alkylation sont exprimées en µmole et en µMcm (µmole pour 100 grammes de monomère). Le méthanol (1 ml) ou l'acétylacétone (utilisée en excès) sont utilisés pour stopper les réactions de polymérisation. La N-1,3-diméthylbutyl-N'-phényl-p-phénylènediamine (6PPD) et l'AO2246 sont utilisés comme agent de protection des solutions polymériques obtenues (selon une masse de 0,2 g de chaque pour 100 g d'élastomère).
On extrait ensuite les polybutadiènes des solutions polymériques ainsi obtenues, soit par stripping à la vapeur d'eau en présence de tamolate de calcium et soit un séchage sur rouleaux à 100°C soit un séchage en étuve à 60°C sous vide avec un léger courant d'azote, soit par dévolatilisation sous vide partiel avec balayage à l'azote à 50° C.

### Essai témoin

Dans une bouteille Steinie on introduit successivement 35 ml de solvant méthylcyclohexane, 5,0 grammes de butadiène, 180 µmol de butyloctyl magnésium et une ampoule en verre scellée contenant 20 µmol de Nd(BH₄)₃(THF)₃.
L'ampoule est cassée sous l'effet de l'agitation mécanique puis le milieu réactionnel est chauffé à la température de 60°C. Au bout de 20 minutes, la réaction de polymérisation est stoppée par ajout de méthanol, le polymère est coagulé, anti-oxydé puis séché. Ainsi, 5,0 grammes de polybutadiènes sont obtenus. Les caractérisations de ce polymère sont données dans le tableau ci-après.

### Essai 1

Dans une bouteille Steinie on introduit successivement 35 ml de solvant méthylcyclohexane, 5,2 grammes de butadiène et deux ampoules en verre scellées contenant chacune 21 µmol de Nd(BH₄)₃(THF)₃ et 174 µmol de bis(*ortho*-N,N-diméthylaminobenzyle) de magnésium.
Les ampoules sont brisées sous l'effet de l'agitation mécanique puis le milieu réactionnel est chauffé à la température de 60°C. Au bout de 20 minutes, la réaction de polymérisation est stoppée par ajout de méthanol, le polymère est coagulé, anti-oxydé puis séché. Ainsi, 5,2 grammes de polybutadiènes sont obtenus. Les caractérisations de ce polymère sont données dans le tableau ci-après.

### Essai 2

Dans une bouteille Steinie on introduit successivement 70 ml de solvant méthylcyclohexane, 7,8 grammes de butadiène et deux ampoules en verre scellées contenant chacune 20 µmol de Nd(BH₄)₃(THF)₃ et 181 µmol de bis(*ortho*-N,N-diméthylaminobenzyle) de magnésium.
Les ampoules sont brisées sous l'effet de l'agitation mécanique puis le milieu réactionnel est chauffé à la température de 55°C. Au bout de 7 minutes, la réaction de polymérisation est stoppée par ajout de méthanol, le polymère est coagulé, anti-oxydé puis séché. Ainsi, 7,8 grammes de polybutadiènes sont obtenus. Les caractérisations de ce polymère sont données dans le tableau ci-après.

**Tableau de résultats**

| réf | Nd(BH₄)₃(THF)₃ µmol (µMcm) | Co-catalyseur | | Rapport Nd / Mg | S/M | Conversion (durée en min.) | Activité moyenne Kg/mol[Nd]/h | Mn en g/mol^{b} (IP) | 1,2^{c} | 1,4-trans^{c} | 1,4-cis^{c} | %Chaînes fonctionnalisées^{d} |
|---|---|---|---|---|---|---|---|---|---|---|---|---|
| | | Nature^{a} | µmol (µMcm) | | | | | | | | | |
| Témoin | 20 (400) | BOMAG | 180 | 9 | 5,4 | 100% (20) | 750 | 29 250 (1,33) | 46,1 | 29,4 | 24,5 | na^{e} |
| Essai 1 | 21 (404) | Mg(RN)₂ | 174 | 8,3 | 5,2 | 100% (20) | 780 | 27 500 (1,28) | 46,6 | 28,7 | 24,7 | 100% |
| Essai 2 | 20 (256) | Mg(RN)₂ | 181 | 9,1 | 6,9 | 100% (7) | 3343 | 30 000 (1,33) | 42,1 | 33,3 | 24,6 | 100% |

| | | | | | | | | | | | | |
|---|---|---|---|---|---|---|---|---|---|---|---|---|
| ^{a} :BOMAG = butyloctylmagnésium ; Mg(RN)2 = bis(ortho-N,N-diméthylaminobenzyle) de magnésium ^{b} : Mn et Ip sont déterminés par chromatographie d'exclusion stérique (Annexe 1) ^{c} : La microstructure est déterminée par une méthode de proche infra-rouge (Annexe 2) ^{d} : La proportion de chaînes fonctionnalisées par le groupement diméthylamino-benzyle est déterminée par RMN ¹H et ¹³C (voir annexe 3) ^{e} : na signifie « ne s'applique pas » | | | | | | | | | | | | |

### a) Principe de la mesure:

La chromatographie d'exclusion stérique ou SEC (Size Exclusion Chromatography) permet de séparer les macromolécules en solution suivant leur taille à travers des colonnes remplies d'un gel poreux. Les macromolécules sont séparées suivant leur volume hydrodynamique, les plus volumineuses étant éluées en premier.
Sans être une méthode absolue, la SEC permet d'appréhender la distribution des masses molaires d'un polymère. A partir de produits étalons commerciaux, les différentes masses molaires moyennes en nombre (Mn) et en poids (Mw) peuvent être déterminées et l'indice de polymolécularité (Ip = Mw/Mn) calculé via un étalonnage dit de MOORE.

### b) Préparation du polymère:

Il n'y a pas de traitement particulier de l'échantillon de polymère avant analyse. Celui-ci est simplement solubilisé dans du (tétrahydrofuranne + 1%vol. de diisopropylamine + 1%vol. de triéthylamine + 1%vol. d'eau distillée) à une concentration d'environ 1 g/l. Puis la solution est filtrée sur filtre de porosité 0.45µm avant injection.

### c) Analyse SEC:

L'appareillage utilisé est un chromatographe « WATERS alliance ». Le solvant d'élution est du (tétrahydrofuranne + 1%vol. de diisopropylamine + 1%vol. de triéthylamine), le débit de 0,7 ml/min, la température du système de 35°C et la durée d'analyse de 90 min. On utilise un jeu de quatre colonnes WATERS en série, de dénominations commerciales « STYRAGEL HMW7 », « STYRAGEL HMW6E » et deux « STYRAGEL HT6E ».

Le volume injecté de la solution de l'échantillon de polymère est 100 µl. Le détecteur est un réfractomètre différentiel « WATERS 2410 » et le logiciel d'exploitation des données chromatographiques est le système « WATERS EMPOWER».

Les masses molaires moyennes calculées sont relatives à une courbes d'étalonnage réalisées pour des polybutadiènes de microstructure suivante : 11 % massique de motifs type 1-2 et 48 % massique de motifs type 1-4 trans.

On a utilisé la technique de dosage appelée « proche infrarouge » (NIR). Il s'agit d'une méthode indirecte faisant appel à des élastomères « témoin » dont la microstructure a été mesurée par la technique de RMN¹³C. On utilise la relation quantitative (loi de Beer-Lambert) existant entre la répartition des monomères dans un élastomère et la forme du spectre NIR de celui-ci. Cette technique est mise en oeuvre en deux étapes :
1) Etalonnage :
   - On procède à l'acquisition des spectres respectifs des élastomères « témoin ».
   - On établit un modèle mathématique associant une microstructure à un spectre donné, ceci à l'aide de la méthode de régression PLS (Partial Least Squares) reposant sur une analyse factorielle des données spectrales. Les deux documents suivants traitent d'une manière approfondie de la théorie et de la mise en oeuvre de cette méthode d'analyse de données « multi-variées » :
      (1) P. GELADI et B. R. KOWALSKI « Partial Least Squares régression : a tutorial », Analytica Chimica Acta, vol. 185, 1-17 (1986).
      (2) M. TENENHAUS « La régression PLS - Théorie et pratique » Paris, Editions Technip (1998).
2) Mesure :
   - On procède à un enregistrement du spectre de l'échantillon.
   - On réalise le calcul de la microstructure.

Les polymères sont analysés par RMN ¹H et ¹³C au moyen d'un spectromètre Bruker AV500 équipé d'une sonde BBI ¹H-X 5 mm. Le solvant utilisé pour l'analyse est un mélange de CS₂ et de C₆D₁₂. La calibration est réalisée à partir de l'impureté protonée du CS2, avec un déplacement chimique de 7,12 ppm.

Les spectres RMN ¹H et ²D confirme la présence du groupement diméthylaminobenzyle en bout de chaîne des polybutadiènes préparés. Les déplacements chimiques de chaque type de proton ont été attribués et sont renseignés sur la figure. :

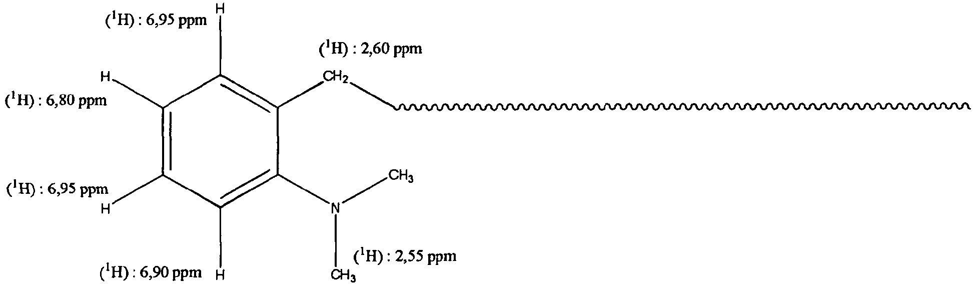

La quantification du nombre de chaînes fonctionnelles est réalisée soit à partir du signal du proton aromatique à 6,80 ppm, qui intègre pour un proton ou à partir du massif compris entre 2,7 et 2,3 ppm (groupements -N(CH₃)₂ et CH₂ en alpha du noyau aromatique), qui intègre pour 8 protons. Ces valeurs sont rapportées à l'intégration des signaux caractéristiques des motifs 1,4-cis, 1,4-trans et 1,2 du polybutadiène. Les deux méthodes de calcul conduisent à des valeurs statistiquement identiques entre elles.

## Revendications

1. - Composé organométallique répondant à la formule (I): 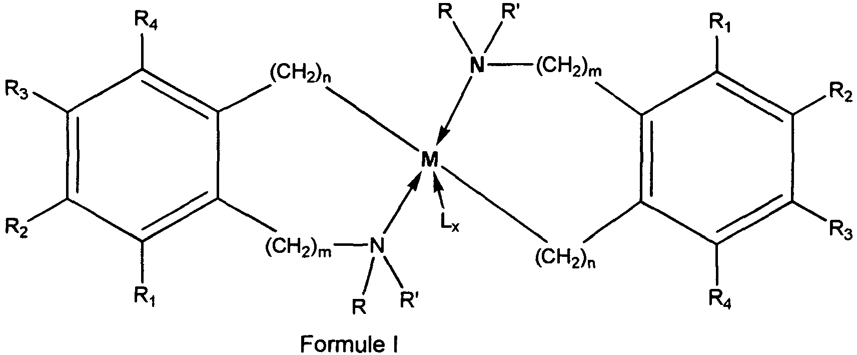 dans laquelle,
- M est un métal appartenant à la 2^{ème} colonne de la classification périodique, choisi parmi Be, Mg, Sr, Ba, et Ra;
- R1, R2, R3, R4, identiques ou différents entre eux, sont des atomes d'hydrogène ou des substituants alkyles, linéaires ou ramifiés, ou aryles, substitués ou non, éventuellement liés entre eux pour former au moins un cycle composé de 5 ou 6 atomes, ou au moins un noyau aromatique;
- R et R', identiques ou différents entre eux, désignent des substituants alkyles, linéaires ou ramifiés, ou aryles, substitué ou non;
- L est une base de Lewis ;
- x est un nombre entier qui vaut 0, 1, 2, 3 ou 4 ;
- m est un nombre entier d'une valeur allant de 0 à 3 ;
- n est un nombre entier d'une valeur allant de 1 à 3.

2. - Composé organométallique selon la revendication 1, **caractérisé en ce que** dans la formule (I) M représente le magnésium.

3. - Composé organométallique selon la revendication 1 ou 2, **caractérisé en ce que** dans la formule (I) R1, R2, R3, R4 sont identiques et représentent des atomes d'hydrogène.

4. - Composé organométallique selon l'une des revendications 1 à 3, **caractérisé en ce que** dans la formule (I) R et R' sont identiques et représentent des groupements méthyle, éthyle, iso-propyle, n-butyle, iso-butyle ou tert-butyle.

5. - Composé organométallique selon l'une des revendications 1 à 4, **caractérisé en ce que** le composé organométallique de formule (I) est le bis(ortho-N,N-diméthylaminobenzyle) de magnésium.

6. - Procédé de préparation d'un composé organométallique de formule (I) selon les revendications 1 à 5, comprenant les étapes
(a) de synthèse d'un sel à base d'un métal alcalin répondant à la formule (II), 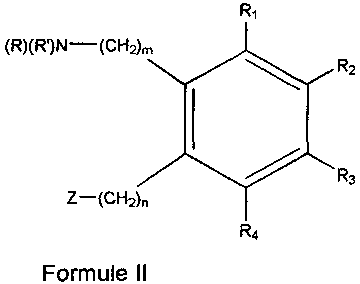 dans laquelle R1, R2, R3, R4, R, R', n et m sont tels que définis dans les revendication 1 ou 5 et Z est un atome de lithium, de sodium ou de potassium ;
(b) de réaction du composé de formule (II) obtenu dans l'étape précédente sur un sel d'un métal appartenant à la 2^{ème} colonne de la classification périodique,
(c) de récupération du composé organométallique de formule (I) obtenu.

7. - Procédé de préparation selon la revendication 6 , **caractérisé en ce que** dans l'étape (a), la synthèse de sel de métal alcalin est réalisée à partir du diméthylaminotoluène en présence d'un un organolithien et d'un alcoolate de potassium.

8. - Utilisation d'un composé organométallique de formule (III) 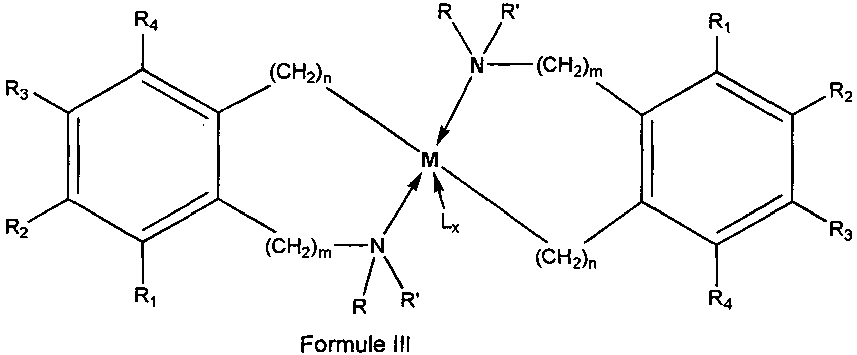 dans laquelle,
- M est un métal appartenant à la 2^{ème} colonne de la classification périodique;
- R1, R2, R3, R4, identiques ou différents entre eux, sont des atomes d'hydrogène ou des substituants alkyles, linéaires ou ramifiés, ou aryles, substitués ou non, éventuellement liés entre eux pour former au moins un cycle composé de 5 ou 6 atomes, ou au moins un noyau aromatique;
- R et R', identiques ou différents entre eux, désignent des substituants alkyles, linéaires ou ramifiés, ou aryles, substitué ou non;
- L est une base de Lewis ;
- x est un nombre entier qui vaut 0, 1, 2, 3 ou 4 ;
- m est un nombre entier d'une valeur allant de 0 à 3 ;
- n est un nombre entier d'une valeur allant de 1 à 3,
comme co-catalyseur alkylant dans un système catalytique pour la polymérisation à base d'un sel métallique de terre rare.

9. - Utilisation selon la revendication 8, **caractérisé en ce que** le rapport molaire (composé de formule (III) / métal de terre rare) a une valeur allant de 1,5 à 20.

## Patentansprüche

1. Metallorganische Verbindung der Formel (I): 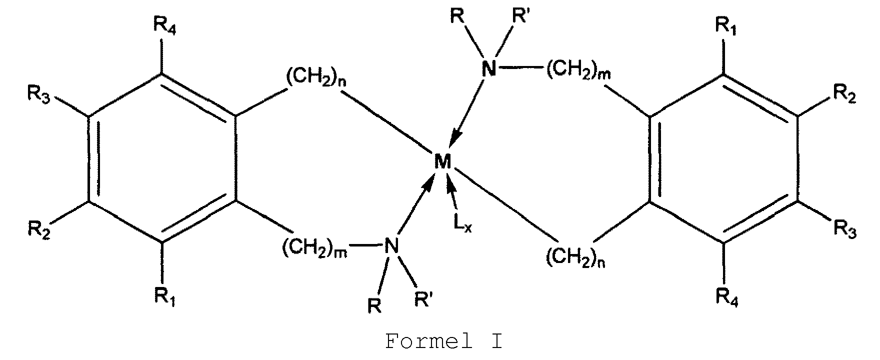 in der
- M für ein Metall der 2. Gruppe des Periodensystems, das aus Be, Mg, Sr, Ba und Ra ausgewählt ist, steht;
- R1, R2, R3 und R4, die gleich oder voneinander verschieden sind, für Wasserstoffatome oder lineare oder verzweigte Alkylsubstituenten oder Arylsubstituenten, die substituiert oder unsubstituiert sind, stehen und gegebenenfalls unter Bildung mindestens eines Rings aus 5 oder 6 Atomen oder mindestens eines aromatischen Kerns miteinander verbunden sind;
- R und R', die gleich oder voneinander verschieden sind, für lineare oder verzweigte Alkylsubstituenten oder Arylsubstituenten, die substituiert oder unsubstituiert sind, stehen;
- L für eine Lewis-Base steht;
- x für eine ganze Zahl steht, die gleich 0, 1, 2, 3 oder 4 ist;
- m für eine ganze Zahl mit einem Wert im Bereich von 0 bis 3 steht;
- n für eine ganze Zahl mit einem Wert im Bereich von 1 bis 3 steht.

2. Metallorganische Verbindung nach Anspruch 1, **dadurch gekennzeichnet, dass** in der Formel (I) M für Magnesium steht.

3. Metallorganische Verbindung nach Anspruch 1 oder 2, **dadurch gekennzeichnet, dass** in der Formel (I) R1, R2, R3 und R4 gleich sind und für Wasserstoffatome stehen.

4. Metallorganische Verbindung nach einem der Ansprüche 1 bis 3, **dadurch gekennzeichnet, dass** in der Formel (I) R und R' gleich sind und für Methyl-, Ethyl-, Isopropyl-, n-Butyl-, Isobutyl- oder tert-Butylgruppen stehen.

5. Metallorganische Verbindung nach einem der Ansprüche 1 bis 4, **dadurch gekennzeichnet, dass** es sich bei der metallorganischen Verbindung der Formel (I) um Bis(ortho-N,N-dimethylaminobenzyl)-magnesium handelt.

6. Verfahren zur Herstellung einer metallorganischen Verbindung der Formel (I) nach den Ansprüchen 1 bis 5, das folgende Schritte umfasst:
(a) Synthese eines Salzes auf Basis eines Alkalimetalls, das der Formel (II) entspricht, 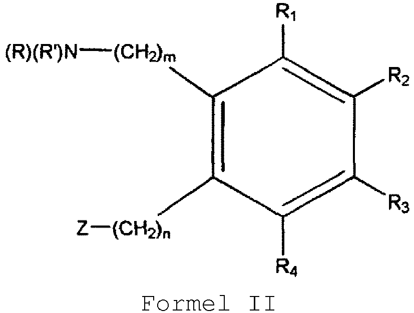 in der R1, R2, R3, R4, R, R', n und m wie in den Ansprüchen 1 bis 5 definiert sind und Z für ein Lithium-, Natrium- oder Kaliumatom steht;
(b) Umsetzung der im vorhergehenden Schritt erhaltenen Verbindung der Formel (II) mit einem Salz eines Metalls der 2. Gruppe des Periodensystems,
(c) Gewinnung der erhaltenen metallorganischen Verbindung der Formel (I).

7. Herstellungsverfahren nach Anspruch 6, **dadurch gekennzeichnet, dass** in Schritt (a) die Synthese des Alkalimetallsalzes ausgehend von Dimethyl-aminotoluol in Gegenwart einer Organolithiumverbindung und eines Kaliumalkoholats durchgeführt wird.

8. Verwendung einer metallorganischen Verbindung der Formel (III) 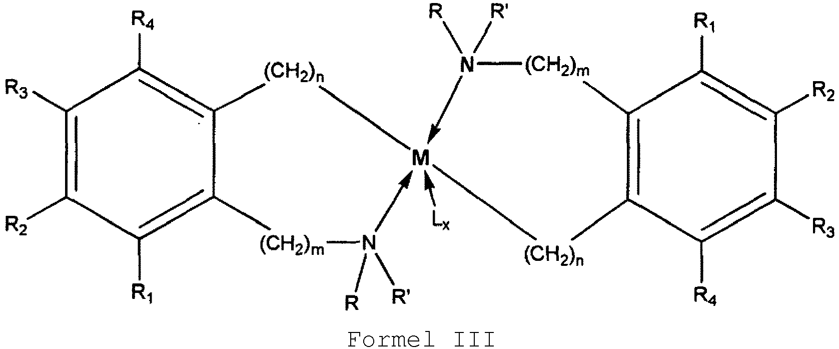 in der
- M für ein Metall der 2. Gruppe des Periodensystems steht;
- R1, R2, R3 und R4, die gleich oder voneinander verschieden sind, für Wasserstoffatome oder lineare oder verzweigte Alkylsubstituenten oder Arylsubstituenten, die substituiert oder unsubstituiert sind, stehen und gegebenenfalls unter Bildung mindestens eines Rings aus 5 oder 6 Atomen oder mindestens eines aromatischen Kerns miteinander verbunden sind;
- R und R', die gleich oder voneinander verschieden sind, für lineare oder verzweigte Alkylsubstituenten oder Arylsubstituenten, die substituiert oder unsubstituiert sind, stehen;
- L für eine Lewis-Base steht;
- x für eine ganze Zahl steht, die gleich 0, 1, 2, 3 oder 4 ist;
- m für eine ganze Zahl mit einem Wert im Bereich von 0 bis 3 steht;
- n für eine ganze Zahl mit einem Wert im Bereich von 1 bis 3 steht;
als alkylierender Cokatalysator in einem katalytischen System für die Polymerisation auf Basis eines Seltenerdmetallsalzes.

9. Verwendung nach Anspruch 8, **dadurch gekennzeichnet, dass** das Molverhältnis (Bindung der Formel (III)/Seltenerdmetall) einen Wert im Bereich von 1,5 bis 20 aufweist.

## Claims

1. - Organometallic compound corresponding to the formula (I): 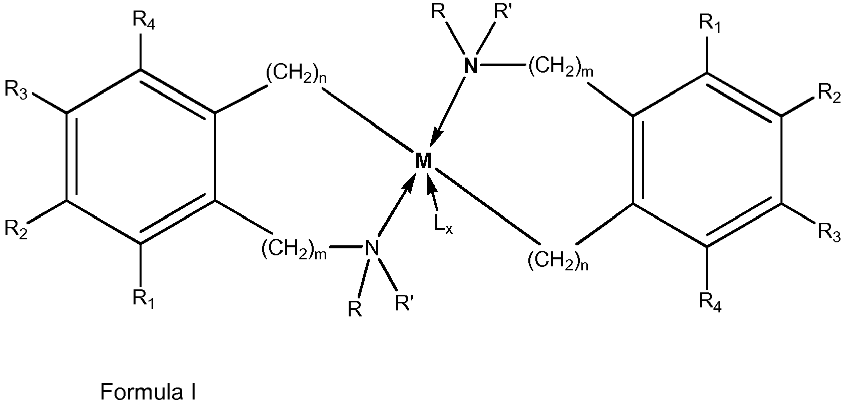 in which:
- M is a metal belonging to the 2^{nd} column of the Periodic Table, chosen from Be, Mg, Sr, Ba and Ra;
- R₁, R₂, R₃, R₄, which are identical to or different from one another, are hydrogen atoms or linear or branched alkyl substituents, or aryl substituents, which are substituted or unsubstituted, optionally bonded together to form at least one ring composed of 5 or 6 atoms, or at least one aromatic ring;
- R and R', which are identical to or different from one another, denote linear or branched alkyl substituents, or aryl substituents, which are substituted or unsubstituted;
- L is a Lewis base;
- x is an integer that is equal to 0, 1, 2, 3 or 4;
- m is an integer having a value ranging from 0 to 3;
- n is an integer having a value ranging from 1 to 3,

2. - Organometallic compound according to Claim 1, **characterized in that** in the formula (I) M represents magnesium.

3. - Organometallic compound according to Claim 1 or 2, **characterized in that** in the formula (I) R₁, R₂, R₃ and R₄ are identical and represent hydrogen atoms.

4. - Organometallic compound according to one of Claims 1 to 3, **characterized in that** in the formula (I) R and R' are identical and represent methyl, ethyl, isopropyl, n-butyl, isobutyl or *tert*-butyl groups.

5. - Organometallic compound according to one of Claims 1 to 4, **characterized in that** the organometallic compound of formula (I) is bis(*ortho*-*N,N*-dimethylaminobenzyl) magnesium.

6. - Method of preparing an organometallic compound of formula (I) according to Claims 1 to 5, comprising the steps:
(a) of synthesizing a salt based on an alkali metal and corresponding to the formula (III): 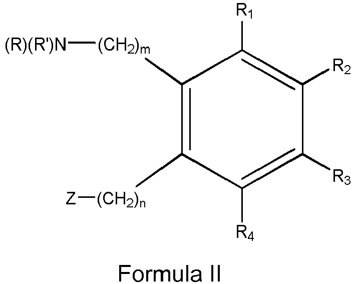 in which R₁, R₂, R₃, R₄, R, R', n and m are as defined in Claims 1 or 5 and Z is a lithium, sodium or potassium atom;
(b) of reacting the compound of formula (II) obtained in the preceding step with a salt of a metal belonging to the 2^{nd} column of the Periodic Table;
(c) of recovering the organometallic compound of formula (I) obtained.

7. - Preparation method according to Claim 6, **characterized in that** in step (a), the alkali metal salt is synthesized starting from dimethylaminotoluene in the presence of an organolithium and a potassium alcoholate.

8. - Use of an organometallic compound of formula (III): 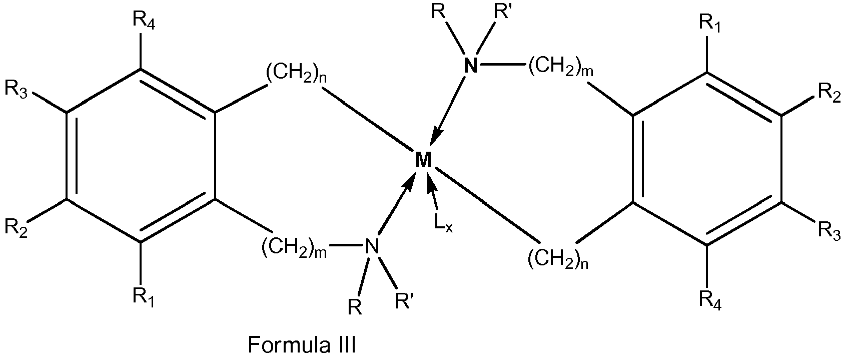 in which,
- M is a metal belonging to the 2^{nd} column of the Periodic Table;
- R₁ R₂, R₃ and R₄, which are identical to or different from one another, are hydrogen atoms or linear or branched alkyl substituents, or aryl substituents, which are substituted or unsubstituted, optionally bonded together to form at least one ring composed of 5 or 6 atoms, or at least one aromatic ring;
- R and R', which are identical to or different from one another, denote linear or branched alkyl substituents, or aryl substituents, which are substituted or unsubstituted;
- L is a Lewis base;
- x is an integer which is equal to 0, 1, 2, 3 or 4;
- m is an integer having a value ranging from 0 to 3;
- n is an integer having a value ranging from 1 to 3,
as an alkylating co-catalyst in a catalytic system for polymerization based on a rare-earth metal salt.

9. - Use according to Claim 8, **characterized in that** the (compound of formula (III)/rare-earth metal) molar ratio has a value ranging from 1.5 to 20.
